**Europäisches Patentamt**

**European Patent Office**

**Office européen des brevets**

(19)

(11) Publication number: **0 096 531**
**B1**

(12) **EUROPEAN PATENT SPECIFICATION**

(45) Date of publication of patent specification: **16.09.87**

(51) Int. Cl.⁴: **H 03 K 17/22, G 06 F 1/00**

(21) Application number: **83303140.4**

(22) Date of filing: **01.06.83**

(54) **One-chip semiconductor device incorporating a power-supply-potential detecting circuit with reset function.**

(30) Priority: **30.06.82 JP 113308/82**
**09.06.82 JP 98649/82**

(43) Date of publication of application:
**21.12.83 Bulletin 83/51**

(45) Publication of the grant of the patent:
**16.09.87 Bulletin 87/38**

(84) Designated Contracting States:
**DE FR GB**

(56) References cited:
**US-A-4 013 902**
**US-A-4 048 524**
**US-A-4 173 756**
**US-A-4 296 338**
**US-A-4 296 338**
**US-A-4 301 380**

(73) Proprietor: **FUJITSU LIMITED**
**1015, Kamikodanaka Nakahara-ku**
**Kawasaki-shi Kanagawa 211 (JP)**

(72) Inventor: **Fujita, Kouichi**
**1-10-501, Azamino 3-chome Midori-ku**
**Yokohama-shi Kanagawa 227 (JP)**
Inventor: **Shirato, Moritoshi**
**Minamoto-so 2F-3 15-13, Senba-cho 2-chome**
**Kawagoe-shi Saitama-ken, 350 (JP)**

(74) Representative: **Skone James, Robert Edmund**
**et al**
**GILL JENNINGS & EVERY 53-64 Chancery Lane**
**London WC2A 1HN (GB)**

### Description

The present invention relates to a one-chip semiconductor device such as a one-chip microcomputer incorporating a power-supply-potential detecting circuit for resetting the device when the power supply potential is lower than a predetermined value.

In a semiconductor device or integrated circuit such as a one-chip microcomputer, if the rated power supply potential is 5V, the device normally operates at its rated accuracy in the range of ±5% to ±10% of the rate potential. When the power supply potential deviates from the above-mentioned range, the device may perform a logically erroneous operation and may overrun.

To prevent the device from erroneously operating, a power-supply-potential detecting circuit is provided. When the power supply potential becomes lower than a detection potential of the circuit, the circuit generates a signal for resetting the device.

In a one-chip semiconductor device incorporating such a power-supply-potential detecting circuit, it is naturally checked whether the device operates normally in the predetermined range of the rated power potential. In addition, it is necessary to check whether the device operates normally when the power supply potential is between the lower limit of the above-mentioned range and the detection potential, since customers may use the device below the lower limit.

In the above-mentioned one-chip semiconductor device incorporating such a power-supply-potential detecting circuit, however, there is an area between the lower limit of the above-mentioned range and the detection potential of the power-supply-potential detecting circuit which cannot be checked. For example, if the detection potential of the circuit is about 4.0V, the circuit can check whether the device operates normally only when the power supply potential is higher than, at most, 4.1V due to the manufacturing fluctuation. That is, the area between 4.0V to 4.1V cannot be checked.

US—A—4 296 338 discloses a power on/low voltage reset circuit which is implemented on a micro-computer chip which provides a substantially instantaneous reset signal when a predetermined fraction of the power supply voltage falls below a predetermined reference voltage for maintaining the micro-computer in a reset state for a predetermined length of time after the supply voltage has reached a minimum operating value. The reset circuit includes an input terminal via which a test mode signal can be applied. When the test mode signal is high, the reset signal generating means is disabled.

The main problem with this prior art is that the test mode signal has to be generated by a remote device or manually.

In accordance with the present invention, a semiconductor device comprises first and second power supply terminals, the potential ($V_{CC}$) at the first power supply terminal in use being higher than that at the second power supply terminal and normally lying in a rated range (R); an internal circuit to which the potentials of the first and second power supply terminals are applied; a power-supply-potential detecting circuit connected to the first and second power supply terminals and to the internal circuit for detecting the potential at the first power supply terminal and for generating a reset signal (RST) for resetting the internal circuit when the potential at the first power supply terminal is lower than a predetermined value ($V_D$) lower than the lower limit of the rated range; and reset inhibiting means for inhibiting the effect of the reset signal when the device is in a check mode, and is characterised in that the reset inhibiting means comprises a flip-flop set and reset by the internal circuit, and a gate circuit having a first input connected to the output of the power-supply-potential detecting circuit, a second input connected to the output of the flip-flop, and an output connected to the internal circuit whereby when the flip-flop is set by the internal circuit, the gate circuit permits transmission of the reset signal (RST) and when the semiconductor device is being checked, the flip-flop is reset by the internal circuit to cause the gate circuit to inhibit transmission of the reset signal (RST) to enable the operation of the device to be checked when the power supply potential lies in a range (R') between the lower limit of the rated range and the predetermined value ($V_D$).

With this invention a one-chip semiconductor device incorporating a power-supply-potential detecting circuit is provided, in which it is possible automatically to check whether the device operates normally when the power supply potential is equal to or higher than the detection potential of the circuit.

The invention may be used with conventional power-supply-potential detecting circuits such as that shown in US—A—4,301,380. Such circuits require three subsidiary circuits: a reference voltage generator for generating a reference voltage; a voltage divider for generating a voltage proportional to the power supply voltage; and a comparator for comparing the voltage of the divider with the reference voltage. The present invention also provides improved power-supply-potential detecting circuits used for the one-chip semiconductor device. The new circuits described in this specification constitute an improvement of the known circuits by combining the previously separate functions of the reference voltage generator and the voltage divider.

Some examples of semiconductor devices in accordance with the present invention will now be described with reference to the accompanying drawings, wherein:—

Figure 1 is a diagram illustrating a reset operation of a one-chip semiconductor device incorporating a power-supply-potential detecting circuit;

Figure 2 is a block diagram of an embodiment of the one-chip semiconductor device incorporating a power-supply-potential detecting circuit;

Fig. 3 is a circuit diagram of a first example of the power-supply-potential detecting circuit of Fig. 2;

Fig. 4 is a waveform diagram of the signals of the circuit of Fig. 3;

Fig. 5 is a circuit diagram of a second example of the power-supply-potential detecting circuit of Fig. 2;

Fig. 6 is a waveform diagram of the signals of the circuit of Fig. 5;

Fig. 7 is a circuit diagram of a third example of the power-supply-potential detecting circuit of Fig. 2;

Fig. 8 is a waveform diagram of the signals of the circuit of Fig. 7;

Fig. 9 is a circuit diagram of a fourth example of the power-supply-potential detecting circuit of Fig. 2;

Fig. 10 is a circuit diagram of a fifth example of the power-supply-potential detecting circuit of Fig. 2;

Fig. 11 is a waveform diagram of the signals of the circuit of Fig. 10;

Fig. 12 is a circuit diagram of a sixth example of the power-supply-potential detecting circuit of Fig. 2;

Fig. 13 is a circuit diagram of a seventh example of the power-supply-potential detecting circuit of Fig. 2;

Fig. 14 is a diagram of the threshold potential $V_{th}$ of a complementary metal oxide semiconductor (CMOS) inverter;

Fig. 15 is a waveform diagram of the signals of the circuit of Fig. 3;

Fig. 16 is a circuit diagram of an eighth example of the power-supply-potential detecting circuit of Fig. 2; and,

Fig. 17 is a waveform diagram of the signals of the circuit of Fig. 16.

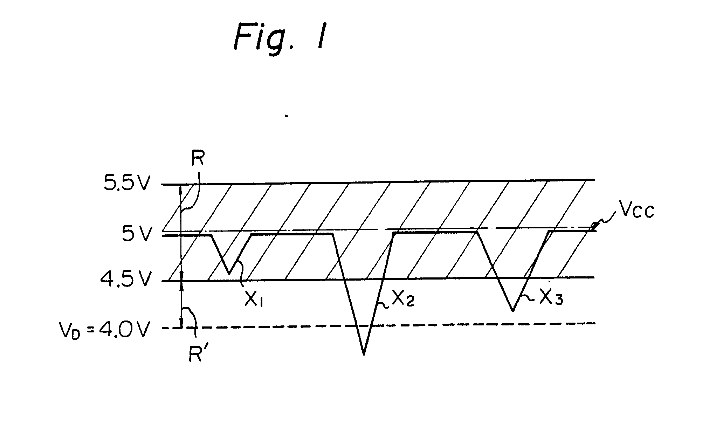

First, the reset operation of a one-chip semiconductor device incorporating a power-supply-potential detecting circuit will be explained with reference to Fig. 1. In Fig. 1, $V_{CC}$ designates the potential of the power supply for the device, and $V_D$ designates a predetermined detection potential. Here, it is assumed that the rated potential of the power supply $V_{CC}$ is 5V and its allowance or range R is 4.5 to 5.5V, as indicated by the shaded portion. If the power supply potential $V_{CC}$ deviates from the range R, it may be necessary to reset the device so that a logically-erroneous operation is not performed. For this purpose, it is preferable that the detection potential $V_D$ be always consistent with the lower limit of the range R, i.e., 4.5V. Actually, the detection potential $V_D$ is, however, set lower than the lower limit in view of manufacturing fluctuations. For example, the detection potential $V_D$ is set at 4.0V, as shown in Fig. 1.

During the test or check mode, first, it is checked whether the device normally operates when the power supply potential $V_{CC}$ is within the range R. Second, it is checked whether a reset operation is performed when the power supply potential $V_{CC}$ reaches the detection potential $V_D$. That is, as illustrated by $X_1$ in Fig. 1, it is checked whether the device normally operates when the power supply potential $V_{CC}$ is within the range R. In addition, as illustrated by $X_2$ in Fig. 1, it is checked whether a reset operation is performed when the power supply potential $V_{CC}$ becomes lower than the detection potential $V_D$.

It should be also noted that customers may use the above-mentioned semiconductor device within a range R' between the lower limit of the rated range R and the detection potential $V_D$. Therefore, it is necessary to check whether the device normally operates when the power supply potential $V_{CC}$ is within the range R' as indicated by $X_3$ in Fig. 1. However, due to the presence of the detection potential $V_D$, it is not completely possible to check whether the device normally operates within the range R' in the proximity of $V_D$, since a reset operation may be performed.

According to the present invention, it is possible to check whether the device normally operates within the entire range R' as well as the range R.

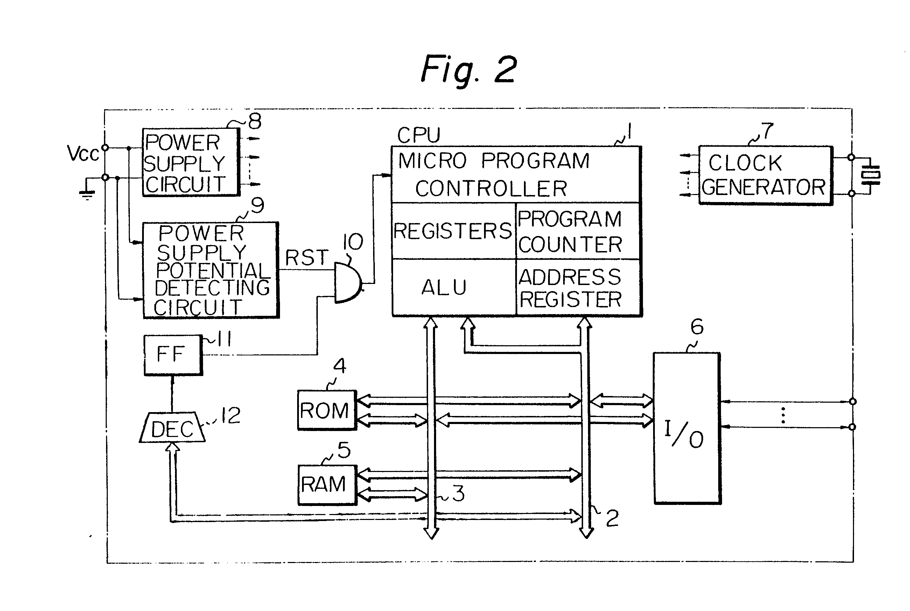

In Fig. 2, which illustrates an embodiment of the present invention, a one-chip microcomputer is illustrated. The one-chip microcomputer comprises a central processing unit 1 (CPU) including a micro program controller; registers, such as a command register and a data register; an arithmetic logic unit (ALU) connected to the registers for performing an arithmetic logic operation; an address counter; an address register connected to the address counter; and the like.

The one-chip microcomputer further comprises an address bus 2, a data bus 3, a read-only memory (ROM) 4 for storing program sequences, constants, and the like, a random access memory (RAM) 5 for storing temporary data, input/output (I/O) interfaces 6, a clock generator 7 for generating interruption signals or the like, a power supply curcuit 8 for applying power potentials to each portion of the microcomputer, a power-supply-potential detecting circuit 9, and AND circuit 10, and a flip-flop 11.

In the microcomputer as illustrated in Fig. 2, when the power supply potential $V_{CC}$ temporarily becomes lower than the power limit of allowance thereof, the content of the RAM 5 may be inverted from "1" to "0" or vice versa. In addition, the contents of the registers and the program counter of the CPU 1 may be changed. In this case, although the microcomputer continues to operate without changing its appearance, the program may overrun, so that the following operation will not be guaranteed.

The above-mentioned state in which program overruns are generated can be avoided by the power-supply-potential detecting circuit 9. That is, the power-supply-potential detecting circuit 9 detects the power supply potential $V_{CC}$ and generates a reset signal RST when the power supply potential $V_{CC}$ becomes lower than a predetermined detection potential $V_D$. Upon receipt of the reset signal RST through the AND circuit 10, the micro program controller of the CPU 1 resets, i.e., initializes the registers and the program counter thereof by using a clock signal of the clock generator 7. Thus, the microcomputer is initialized to restart the operation from the beginning.

The AND circuit 10 and the flip-flop 11 are provided for inhibiting the transmission of the reset signal RST of the power-supply-potential detecting circuit 9 during the check mode. That is, during the check mode, a control signal is supplied from a decoder 12, so as to reset the flip-flop 11, which, in turn, generates a low-potential signal "0". As a result, the AND circuit 10 inhibits the transmission of the reset signal RST of the power-supply-potential detecting circuit 9. During the usual mode, another control signal is supplied from the decoder 12 so as to set the flip-flop 11 which, in turn, generates a high-potential signal "1". As a result, the reset signal RST of the power-supply-potential detecting circuit 9 is transmitted through the AND circuit 10 to the micro program controller of the CPU 1, thereby resetting the registers and the program counter thereof.

Thus, during the check mode, it is possible to check whether the one-chip microcomputer normally operates even when the power supply potential $V_{CC}$ is lower than the detection potential $V_D$.

The decoder 12 resets the flip-flop 11 when the CPU 1 generates a specified address. As a result, the transmission of the reset signal RST is inhibited. After the check mode, the CPU 1 sets the flip-flop 11.

In addition, in order to reset the device from the exterior, a reset terminal and an OR circuit is provided between the output of the AND circuit 10 and the CPU 1. In this case, a reset signal is supplied from the reset terminal via the OR circuit to the CPU 1.

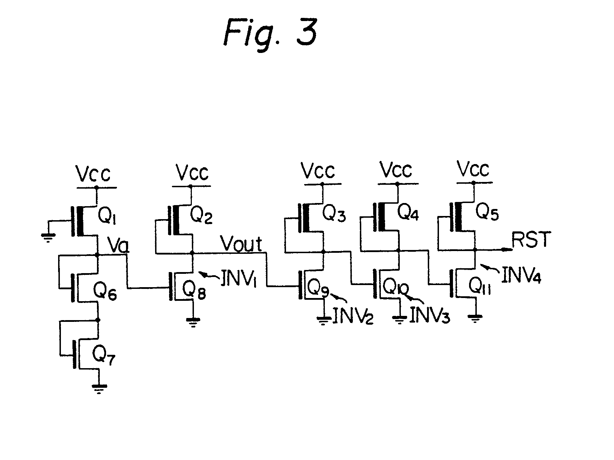

The power-supply-potential detecting circuit 9 will now be explained in more detail with reference to Figs. 3 through 17.

In Fig. 3, an enhancement/depletion (E/D) MOS circuit is used. That is, the power-supply-potential detecting circuit 9 comprises depletion-type MOS transistors $Q_1$ through $Q_5$ and enhancement-type MOS transistors $Q_6$ through $Q_{11}$. The gate of the transistor $Q_1$ is grounded, and, accordingly, this transistor $Q_1$ serves as a resistance. The transistors $Q_6$ and $Q_7$ have gates connected to the drains thereof and, accordingly, serve as MOS diodes. The serial configuration of the two transistors $Q_6$ and $Q_7$ is helpful in effectively driving the following stage transistor $Q_8$ which, in combination with the transistor $Q_2$, forms an inverter $INV_1$.

The following transistors $Q_3$ and $Q_9$, $Q_4$ and $Q_{10}$, and $Q_5$ and $Q_{11}$ also form inverters $INV_2$, $INV_3$, $INV_4$, respectively, which inverters are, however, used for shaping the output $V_{out}$ of the inverter $INV_1$ so as to generate a reset signal RST.

Note that the threshold potential of the inverter $INV_1$ is the same as the threshold potential $V_{th}$ of the transistor $Q_8$.

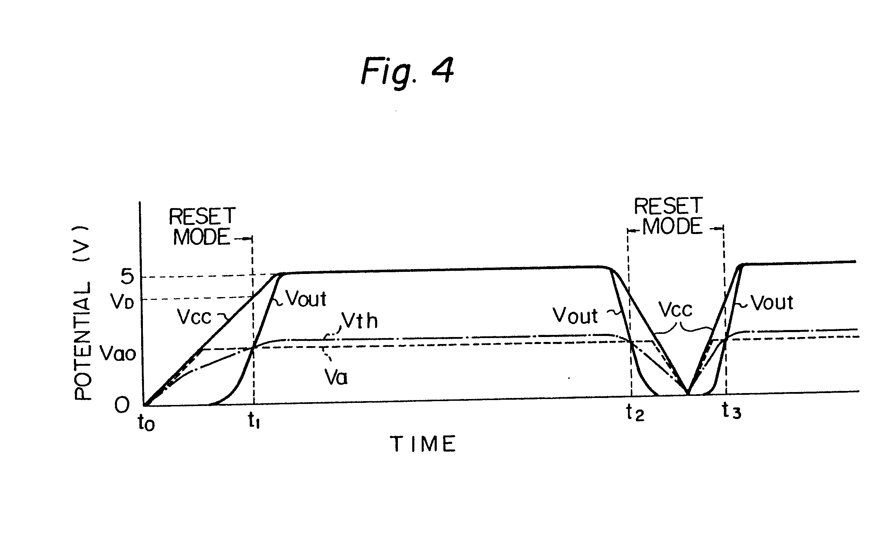

As illustrated in Fig. 4, when the power supply potential $V_{CC}$ is low, the transistors $Q_6$ and $Q_7$ are cut off, so that the potential $V_a$ follows the power supply potential $V_{CC}$. In addition, when the power supply potential $V_{CC}$ becomes higher than the threshold potential of the transistor $Q_6$ plus that of the transistor $Q_7$, the potential $V_a$ is a definite value $V_{a0}$ in accordance with the potential characteristics of MOS diodes. Since the saturation characteristics of the potential $V_a$ are better when the load transistor $Q_1$ has a larger resistance, it is preferable that the conductance $g_m$ of the transistor $Q_1$ be small. In the inverter $INV_1$ receiving the potential $V_a$, since its threshold potential $V_{th}$ is dependent on the power supply potential $V_{CC}$, the potential $V_a$ intersects the threshold potential $V_{th}$ of the inverter $INV_1$ at the times $t_1$, $t_2$, and $t_3$, so that the output $V_{out}$ of the inverter $INV_1$ is changed from high to low or vice versa. Thus, a reduction of the power supply potential $V_{CC}$ can be detected. Accordingly, when the output $V_{out}$ of the inverter $INV_1$ is shaped by the following inverters $INV_2$, $INV_3$, and $INV_4$, a stepwise reset signal RST is obtained.

Note that the value of the power supply potential $V_{CC}$ at the time $t_1$, $t_2$, or $t_3$ is called a detection potential $V_D$, which is, for example, 4V.

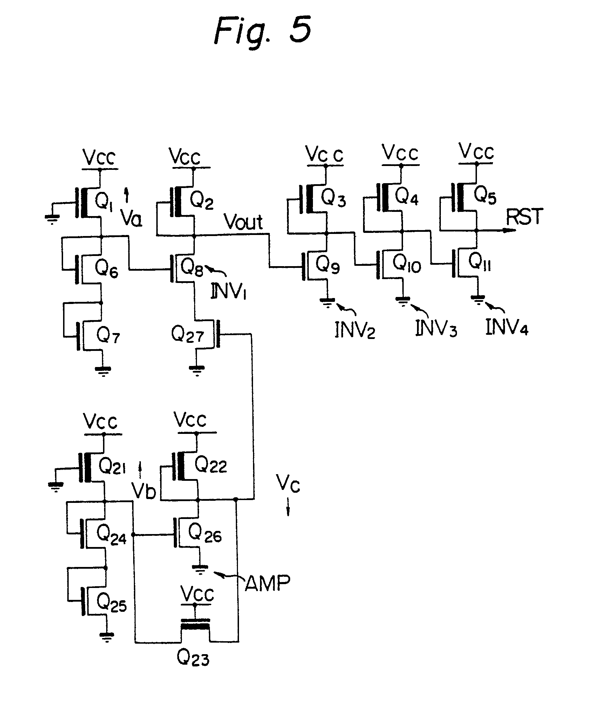

In Fig. 5, depletion-type transistors $Q_{21}$, $Q_{22}$ and $Q_{23}$ and enhancement-type transistors $Q_{24}$, $Q_{25}$, $Q_{26}$, and $Q_{27}$ are added to the elements of Fig. 3, so as to compensate for manufacturing fluctuation. The transistors $Q_{21}$, $Q_{24}$, and $Q_{25}$, have the same characteristics as those of the transistors $Q_1$, $Q_6$, and $Q_7$, respectively, Therefore, the potential $V_b$ is about the same as the potential $V_a$. The transistors $Q_{22}$, $Q_{23}$ and $Q_{26}$ form an inverting-amplifier AMP. In this case, the transistor $Q_{23}$ is a feedback resistance. Accordingly, the gain of the inverting-amplifier AMP is set by the feedback resistance transistor $Q_{23}$. Further, the transistor $Q_{27}$ is interposed between the source of the transistor $Q_8$ and the ground, so that the threshold potential $V_{th}$ of the inverter $INV_1$ is also controlled by the conductance $g_m$ of the transistor $Q_{27}$, which is controlled by the output $V_c$ of the inverting-amplifier AMP.

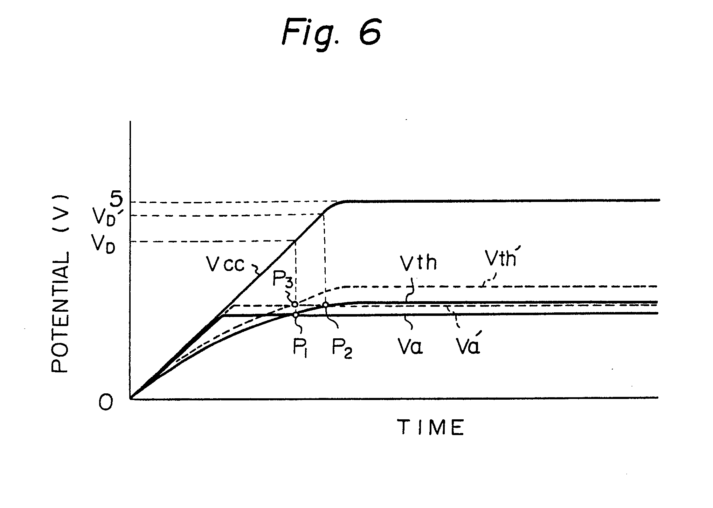

Referring to Fig. 6, when the potential $V_a$ rises up to $V_a'$ due to manufacturing fluctuation of the transistors $Q_1$, $Q_6$, and $Q_7$, the intersecting point is moved from $P_1$ to $P_2$ if the threshold potential $V_{th}$ of the inverter $INV_1$ remains unchanged, so that the detection potential is also moved from $V_D$ to $V_D'$. However, in Fig. 5, the potential $V_b$ changes in the same way as the potential $V_a$ and, accordingly, the potential $V_c$ of the inverting-amplifier AMP changes in the opposite direction to the potential $V_a$. Therefore, if the potential $V_a$ rises, the potential $V_c$ falls so as to reduce the conductance $g_m$ of the transistor $Q_{27}$, i.e., to increase the threshold potential $V_{th}$ of the inverter $INV_1$. As a result, the intersecting point is actually moved from $P_1$ to $P_3$, so that the detection potential remains at $V_D$.

In Fig. 5, note that the gate of the transistor $Q_{26}$ can be also connected directly to the source of the transistor $Q_1$. In this case, the transistors $Q_{21}$, $Q_{24}$, and $Q_{25}$ are omitted.

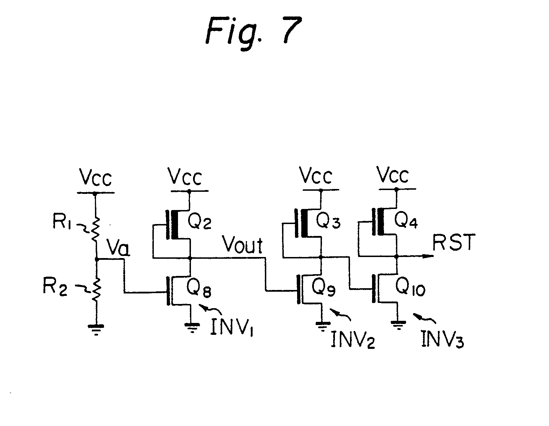

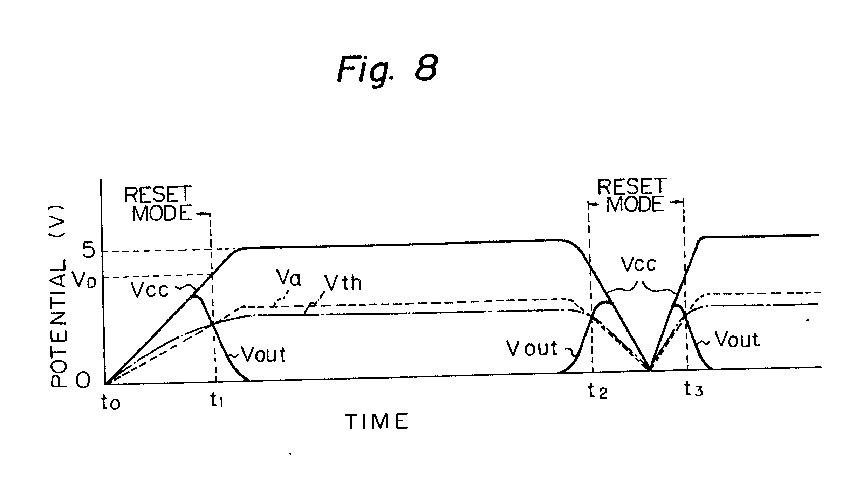

In Fig. 7, resistors $R_1$ and $R_2$ are provided instead of the transistors $Q_1$, $Q_6$, and $Q_7$ of Fig. 3. In addition, the inverter $INV_4$ of Fig. 3 is omitted. In this case, the output $V_{out}$ of the inverter $INV_1$ changes as shown in Fig. 8 in the opposite way as in Fig. 4.

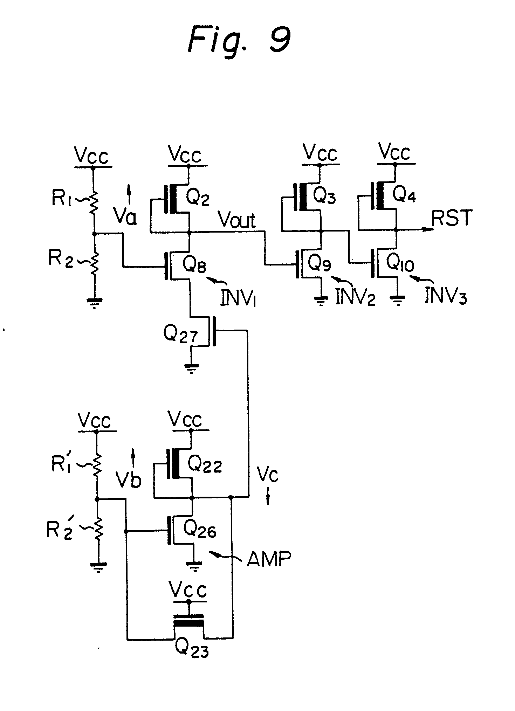

In Fig. 9, resistors $R_1'$ and $R_2'$, and transistors $Q_{22}$, $Q_{23}$, $Q_{26}$, and $Q_{27}$ are added to the elements of Fig. 7, so as to compensate for the manufacturing fluctuation of the circuit of Fig. 7. That is, the circuits of Figs. 7 and 9 correspond to the circuits of Figs. 3 and 5, respectively.

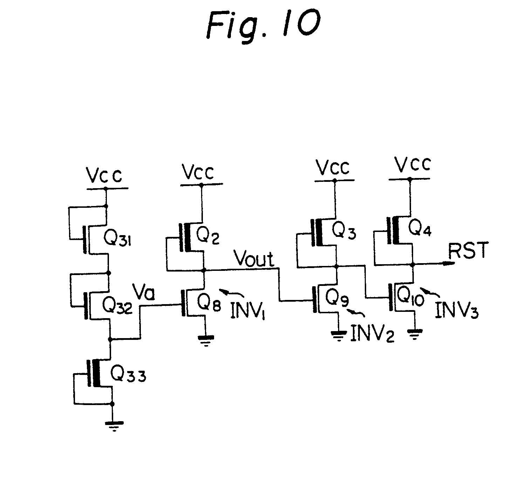

In Fig. 10, enhancement-type transistors $Q_{31}$ and $Q_{32}$ and a depletion-type transistor $Q_{33}$ are provided instead of the resistors $R_1$ and $R_2$ of Fig. 7. The transistors $Q_{31}$ and $Q_{32}$ have gates connected to the drains thereof and, accordingly, are MOS diodes while the transistor $Q_{33}$ has a gate connected to the source thereof and, accordingly, serves as a load.

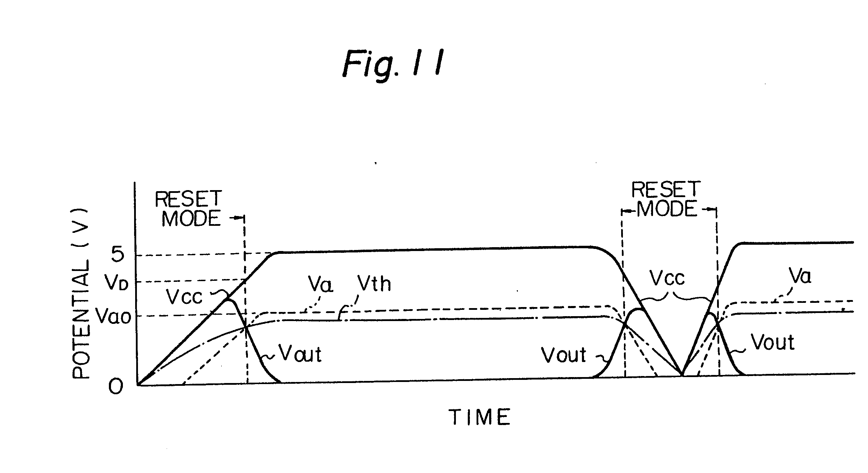

As illustrated in Fig. 11, when the power supply potential $V_{cc}$ is low, the transistors $Q_{31}$ and $Q_{32}$ are cut off, so that the potential $V_a$ remains at the ground potential. In addition, when the power supply potential $V_{cc}$ becomes higher than the threshold potential of the transistor $Q_{31}$ plus that of the transistor $Q_{32}$, the potential $V_a$ is a definite value $V_{a0}$ in accordance with the MOS diode characteristics. In this case, it is also preferable that the conductance $g_m$ of the transistor $Q_{33}$ be small. Thus, the output $V_{out}$ of the inverter $INV_1$ changes in the same way as in Fig. 8.

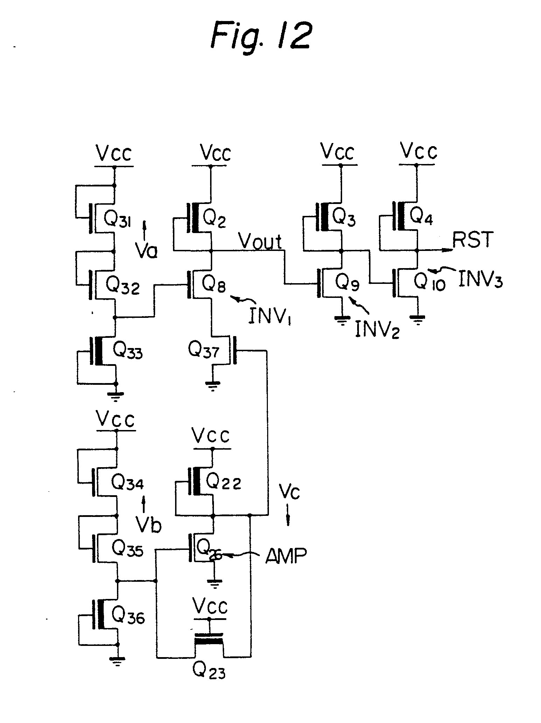

In Fig. 12, enhancement-type transistors $Q_{34}$ and $Q_{35}$ and a depletion-type transistor $Q_{36}$ are provided instead of the resistors $R_1'$ and $R_2'$ of Fig. 9, so as to compensate for the manufacturing fluctuation of the circuit of Fig. 10.

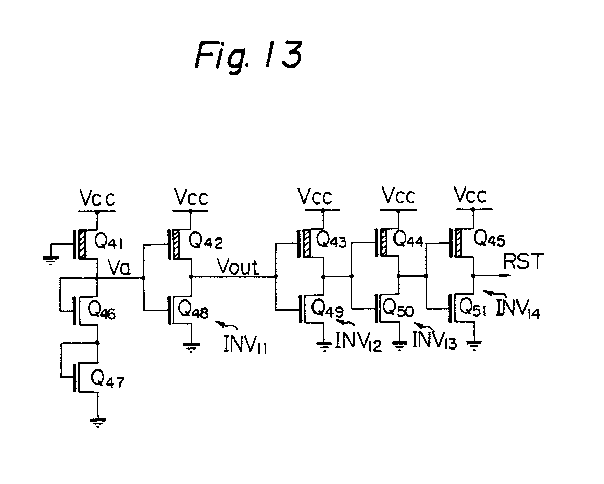

In Fig. 13, a CMOS circuit is used. That is, the power-supply-potential detecting circuit 9 comprises P-channel transistors $Q_{41}$ through $Q_{45}$ and N-channel transistors $Q_{46}$ through $Q_{51}$. The gate of the transistor $Q_{41}$ is grounded and, accordingly, this transistor $Q_{41}$ serves as a resistance. The transistors $Q_{46}$ and $Q_{47}$ have gates connected to the drains thereof and, accordingly, serve as MOS diodes. The serial configuration of the two transistors $Q_{46}$ and $Q_{47}$ is also helpful in effectively driving the following stage CMOS inverter $INV_{11}$ formed by the transistors $Q_{42}$ and $Q_{48}$.

The following transistors $Q_{43}$ and $Q_{49}$, $Q_{44}$ and $Q_{50}$, and $Q_{45}$ and $Q_{51}$ also form CMOS inverters $INV_{12}$, $INV_{13}$, and $INV_{14}$, respectively, which inverters are, however, used for shaping the output $V_{out}$ of the inverter $INV_{11}$ so as to generate a reset signal RST.

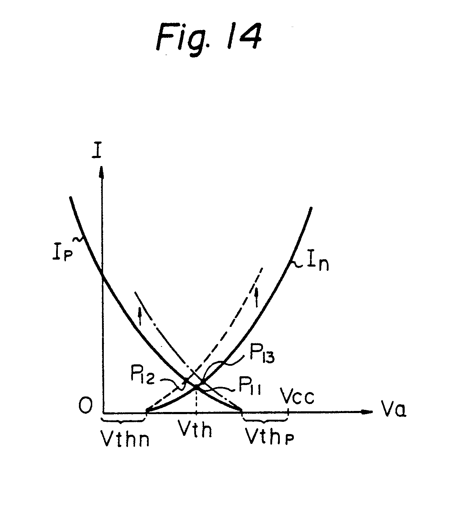

Note that the threshold potential $V_{th}$ of a standard CMOS inverter is half of the power supply potential $V_{cc}$, i.e., $V_{cc}/2$, which will be explained with reference to Fig. 14. In Fig. 14, the ordinate represents a current I, while the abscissa represents a potential such as the potential $V_a$ of Fig. 13. $V_{thn}$ is the threshold potential of the N-channel transistor $Q_{48}$, while $V_{thp}$ is the threshold potential of the P-channel transistor $Q_{42}$. If the inverter $INV_{11}$ is a standard CMOS inverter, $V_a$ equals the threshold potential $V_{th}$ when the current $I_p$ flowing through the P-channel transistor $Q_{42}$ is the same as the current $I_n$ flowing through the N-channel transistor $Q_{48}$. That is, if

$$|V_{thn}| = |V_{thp}|$$

and the current $I_n$ has the same characteristics as the current $I_p$, $V_{th}$ is always $V_{cc}/2$ even when the power supply potential $V_{cc}$ is changed.

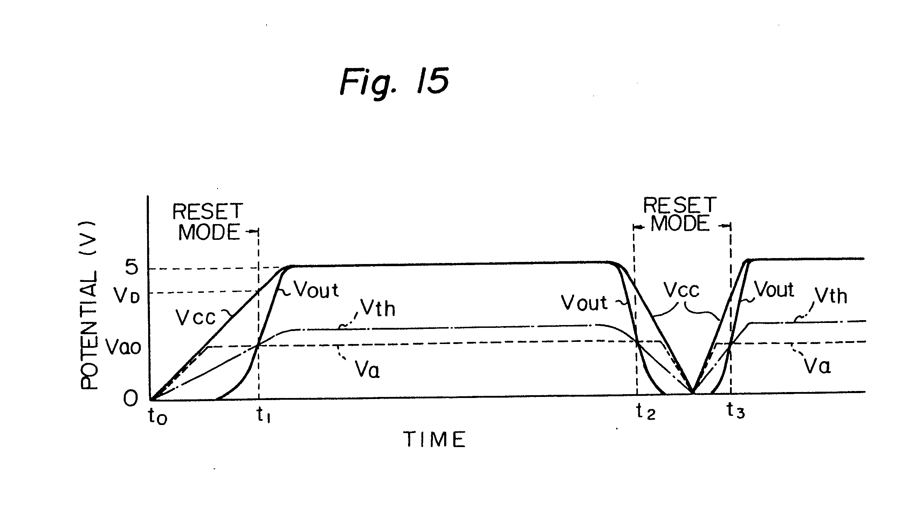

Therefore, as illustrated in Fig. 15, after the potential $V_a$ reaches a predetermined value $V_{a0}$ due to the fact that the gate-to-source potential of each of the transistors $Q_{46}$ and $Q_{47}$ is definite, the transistor $Q_{48}$ has about the same conductance. Contrary to this, even when the potential $V_a$ is definite, the transistor $Q_{42}$ is more deeply biased as the power supply potential $V_{cc}$ rises. As a result, the conductance of the transistor $Q_{42}$ becomes large, and, accordingly, the output $V_{out}$ is pulled up at the time $t_1$. Even in this case, since the transistor $Q_{48}$ remains conductive, the change of the output $V_{out}$ of the inverter $INV_{11}$ is slow. Therefore, the following inverters $INV_{12}$, $INV_{13}$, and $INV_{14}$ shape this output $V_{out}$ so as to generate a stepwise reset signal RST.

Note that the threshold potential $V_{th}$ of the CMOS inverter such as $INV_{11}$ can be changed by changing the size of the P-channel transistor $Q_{42}$ or the N-channel transistor $Q_{48}$. For example, when the size of the N-channel transistor $Q_{48}$ is increased, the current $I_n$ flowing therethrough is increased as indicated by a dotted line in Fig. 14. As a result, the intersecting point is moved from $P_{11}$ to $P_{12}$, so as to reduce the threshold potential $V_{th}$. Therefore, the detection potential $V_D$ is also reduced. Contrary to this, when the size of the P-channel transistor $Q_{42}$ is increased, the current $I_p$ flowing therethrough is increased as indicated by a dash-dotted line in Fig. 14. As a result, the intersecting point is moved from $P_{11}$ to $P_{13}$, so as to increase the threshold potential $V_{th}$. Therefore, the detection potential $V_D$ is also increased. Thus, the threshold potential $V_{th}$ can be arbitrarily set within $V_{thn}$ to $(V_{cc} - V_{thp})$ in Fig. 14, so as to obtain a desired value of $V_D$.

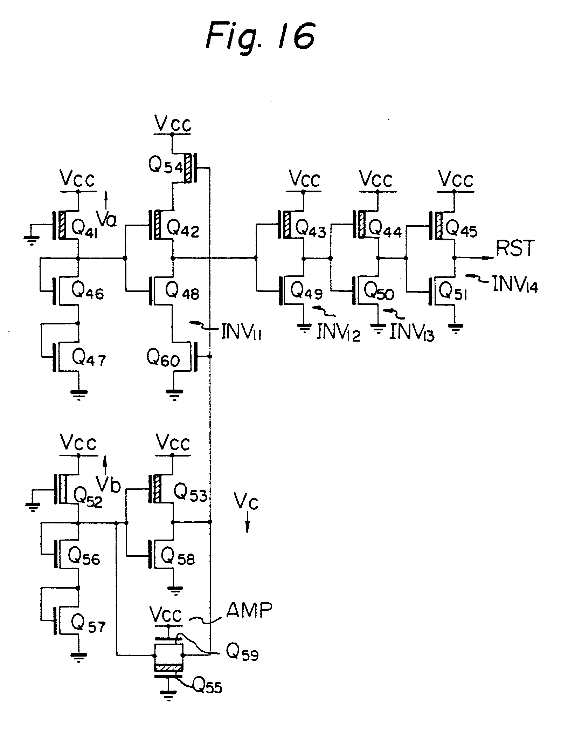

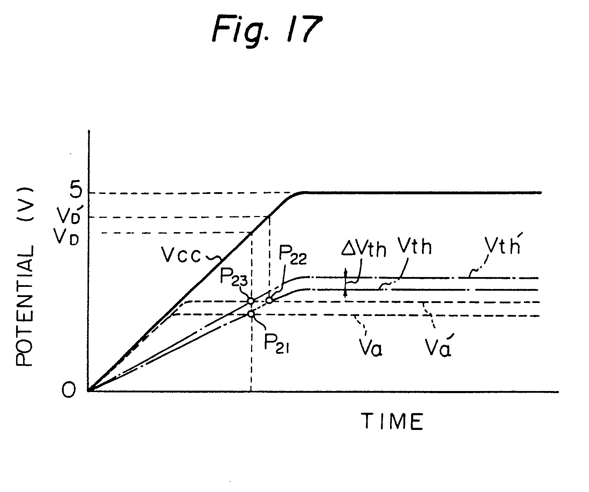

In Fig. 16, P-channel transistors $Q_{52}$ through $Q_{54}$ and N-channel transistors $Q_{56}$ through $Q_{60}$ are added to the elements of Fig. 13, so as to compensate for the manufacturing fluctuation of the circuit of Fig. 13, especially the manufacturing fluctuation of the transistors $Q_{46}$ and $Q_{47}$. If the threshold potential of each of the transistors $Q_{46}$ and $Q_{47}$ is changed by 10%, the potential $V_a$ is changed as indicated by $V_a'$ in Fig. 17. In this state, if the threshold potential $V_{th}$ of the inverter $INV_{11}$ remains unchanged, the intersecting point is moved from $P_{21}$ to $P_{22}$, so that the detection potential is also moved from $V_D$ to $V_D'$. In Fig. 16, however, the added transistors $Q_{52}$ through $Q_{60}$ increase the threshold potential $V_{th}$, so that the intersecting point is actually moved from $P_{21}$ to $P_{23}$. Therefore, the detection potential $V_D$ remains at $V_D$.

The transistors $Q_{52}$, $Q_{56}$, and $Q_{57}$ have the same

characteristics as those of the transistors $Q_{41}$, $Q_{46}$, and $Q_{47}$, respectively. Therefore, the potential $V_b$ is the same as the potential $V_a$. The transistors $Q_{53}$, $Q_{58}$, $Q_{59}$, and $Q_{55}$ form an inverting-amplifier AMP. In this case, the transistors $Q_{59}$ and $Q_{55}$ in combination form a feedback resistance and, accordingly, the gain of the inverting-amplifier AMP is set by this feedback resistance. Further, the transistor $Q_{54}$ is interposed between the power supply $V_{CC}$ and the drain of the transistor $Q_{42}$, and the transistor $Q_{60}$ is interposed between the source of the transistor $Q_{48}$ and the ground. The gates of these transistors $Q_{54}$ and $Q_{60}$ are commonly controlled by the output $V_c$ of the inverting-amplifier AMP.

Referring to Fig. 17, when the potential $V_a$ rises up to $V_a'$ due to the manufacturing fluctuation of the transistors $Q_{41}$, $Q_{46}$, and $Q_{47}$, the intersecting point is moved from $P_{21}$ to $P_{22}$ if the threshold potential $V_{th}$ of the inverter $INV_{11}$ remains unchanged, so that the detection point is also moved from $V_D$ to $V_D'$. However, in Fig. 16, the potential $V_b$ changes in the same way as the potential $V_a$ and, accordingly, the potential $V_c$ of the inverting-amplifier AMP changes in the opposite direction of the potential $V_a$. Since the potential $V_b$ is applied to the transistors $Q_{54}$ and $Q_{60}$, the conductance $g_m$ of the transistor $Q_{54}$ is reduced, while the conductance of the transistor $Q_{60}$ is increased. As a result, the resistance on the P-channel transistors $Q_{54}$ and $Q_{42}$ is reduced, while the resistance on the N-channel transistors $Q_{48}$ and $Q_{60}$ is increased. That is, the slope of the current $I_p$ becomes large, while the slope of the current $I_n$ becomes small, so that the intersecting point (Fig. 14) of the current $I_p$ and the $I_n$ is moved to the right side. Thus, the threshold potential of the inverter $INV_{11}$ is moved from $V_{th}$ to $V_{th}'$, so that the intersecting point of the threshold potential of the inverter $INV_{11}$ and the output $V_a$ is moved from $P_{21}$ to $P_{23}$. Thus, the detection potential is stabilized at $V_D$.

Note that the increase $\Delta V_{th}$ from $V_{th}$ to $V_{th}'$ is adjusted by the gain of the inverting-amplifier AMP or the parameters of the transistors $Q_{54}$ and $Q_{60}$. In addition, the fluctuation of the threshold potential $V_{th}$ of the inverter $INV_{11}$ due to the transistors thereof invites the change of the slope of $V_{th}$, which change is, however, not so large as that due to the manufacturing fluctuation of the transistors $Q_{41}$, $Q_{46}$, and $Q_{47}$. In view of both of the changes, the feedback resistance formed by the transistors $Q_{59}$ and $Q_{55}$ and the like are adjusted.

In Fig. 16, the input of the inverting-amplifier AMP can be also connected directly to the source of the transistor $Q_{41}$ so as to omit the transistors $Q_{52}$, $Q_{56}$, and $Q_{57}$.

As explained hereinbefore, the present invention had an advantage in that it is completely possible to check whether or not the one-chip semiconductor device incorporating a power-supply-potential detecting circuit operates normally.

## Claims

1. A semiconductor device comprising first and second power supply terminals, the potential $(V_{CC})$ at the first power supply terminal in use being higher than that at the second power supply terminal and normally lying in a rated range (R); an internal circuit (1) to which the potentials of the first and second power supply terminals are applied; a power-supply-potential detecting circuit (9) connected to the first and second power supply terminals and to the internal circuit (1) for detecting the potential at the first power supply terminal and for generating a reset signal (RST) for resetting the internal circuit (1) when the potential at the first power supply terminal is lower than a predetermined value $(V_D)$ lower than the lower limit of the rated range; and reset inhibiting means for inhibiting the effect of the reset signal when the device is in a check mode, characterised in that the reset inhibiting means comprises a flip-flop (11) set and reset by the internal circuit (1), and a gate circuit (10) having a first input connected to the output of the power-supply-potential detecting circuit (9), a second input connected to the output of the flip-flop (11), and an output connected to the internal circuit (1) whereby when the flip-flop (11) is set by the internal circuit (1), the gate circuit (10) permits transmission of the reset signal (RST) and when the semiconductor device is being checked, the flip-flop (11) is reset by the internal circuit to cause the gate circuit (10) to inhibit transmission of the reset signal (RST) to enable the operation of the device to be checked when the power supply potential lies in a range (R') between the lower limit of the rated range and the predetermined value $(V_D)$.

2. A device according to claim 1, further comprising a decoder (12) linked between the internal circuit (1) and the input of the flip-flop (11), the decoder (12) being adapted to reset the flip-flop (11) when it receives a special address from the internal circuit (1).

3. A device according to claim 1 or claim 2, wherein the power-supply-potential detecting circuit (9) comprises first load means connected to the first power supply terminal; diode means connected to the first load means and to the second power supply terminal; inverter means $(INV_1)$ connected to the first and second power supply terminals, the inverter means having an input connected to the connection between the first load means and the diode means, and having an output; and waveform shaping means connected to the first and second power supply terminals and to the output of the inverter means for shaping the waveform of the output of the inverter means to generate the reset signal (RST).

4. A device according to claim 3, wherein the first load means comprises a first depletion-type transistor $(Q_1)$ having a drain connected to the first power supply terminal, a gate connected to the second power supply terminal, and a source; the diode means comprises at least one first

enhancement transistor ($Q_6$, $Q_7$) having a drain connected to the gate thereof and connected to the source of the first depletion-type transistor ($Q_1$), and a source connected to the second power supply terminal; and the inverter means ($INV_1$) comprises a second depletion-type transistor ($Q_2$) having a drain connected to the first power supply terminal and a gate connected to the source thereof, and a second enhancement-type transistor ($Q_8$) having a drain connected to the source of the second depletion-type transistor ($Q_2$).

5. A device according to claim 4, wherein the inverter means ($INV_1$) further comprises a third enhancement-type transistor ($Q_{27}$) interposed between the source of the second enhancement-type transistor ($Q_8$) and the second power supply terminal, the device further comprising control means for controlling the conductance of the third enhancement-type transistor ($Q_{27}$).

6. A device according to claim 5, wherein the control means comprises second load means ($Q_{21}$) connected to the first power supply terminal; diode means ($Q_{24}$, $Q_{25}$) connected to the second load means and to the second power supply terminal; and inverting-amplifier means (AMP) connected to the first and second power supply terminals, the inverting-amplifier means having an input connected to the connection between the second load means and the diode means and having an output connected to the gate of the third enhancement-transistor ($Q_{27}$).

7. A device according to claim 5, wherein the control means comprises inverting-amplifier means (AMP) connected to the first and second power supply terminals, the inverting-amplifier means having an input connected to the first load means and an output connected to the gate of the third enhancement-type transistor ($Q_{27}$).

8. A device according to claim 3, wherein the first load means comprises a P-channel transistor ($Q_{41}$) having a drain connected to the first power supply terminal, a gate connected to the second power supply terminal, and a source; the diode means comprises at least one first N-channel transistor ($Q_{46}$, $Q_{47}$) having a drain connected to the gate thereof and connected to source of the first P-channel transistor, and a source connected to the second power supply terminal; and the inverter means ($INV_{11}$) comprises a second P-channel transistor ($Q_{42}$) having a drain connected to the first power supply terminal, a gate connected to the source of the first P-channel transistor, and a source, the inverter means ($INV_{11}$) further comprising a second N-channel transistor ($Q_{48}$) having a drain connected to the source of the second P-channel transistor, a gate connected to the gate of the second P-channel transistor, and a source connected to the second power supply terminal.

9. A device according to claim 8, wherein the inverter means ($INV_{11}$) further comprises a third P-channel transistor ($Q_{54}$) interposed between the first power supply terminal and the drain of the second P-channel transistor, and a third N-channel transistor ($Q_{60}$) interposed between the source of the second N-channel transistor and the second power supply terminal, the device further comprising control means for controlling commonly the conductances of the third P-channel transistor ($Q_{54}$) and the third N-channel transistor ($Q_{60}$).

10. A device according to claim 9, wherein the control means comprises second load means ($Q_{52}$) connected to the first power supply terminal; diode means ($Q_{56}$, $Q_{57}$) connected to the second load means and to the second power supply terminal; and inverting-amplifier means (AMP) connected to the first and second power supply terminals, the inverting-amplifier means having an input connected to the connection between the second load means and the diode means and having an output connected to the gates of the third P-channel transistor ($Q_{54}$) and the third N-channel transistor ($Q_{60}$).

11. A device according to claim 9, wherein the control means comprises inverting-amplifier means (AMP) connected to the first and second power supply terminals, the inverting-amplifier means having an input connected to the first load means and an output connected to the gates of the third P-channel transistor ($Q_{54}$) and the third N-channel transistor ($Q_{60}$).

12. A device according to claim 1 or claim 2, wherein the power supply potential detecting circuit comprises first and second resistance means ($R_1$, $R_2$) connected in series between the first and second power supply terminals; inverter means ($INV_1$) connected to the first and second power supply terminals, the inverter means having an input connected to the connection between the first and second resistance means, and having an output; and a waveform shaping means connected to the first and second power supply terminals and to the output of the inverter means for shaping the waveform of the output of the inverter means to generate the reset signal (RST).

13. A device according to claim 12, wherein the inverter means ($INV_1$) comprises a depletion-type transistor ($Q_2$) having a drain connected to the first power supply terminal and a gate connected to the source thereof, and an enhancement-type transistor ($Q_8$) having a drain connected to the source of the second depletion-type transistor.

14. A device according to claim 13, wherein the inverter means ($INV_1$) further comprises an additional enhancement-type transistor ($Q_{27}$) interposed between the source of the enhancement-type transistor ($Q_8$) and the second power supply terminal, the device further comprising control means for controlling the conductance of the additional enhancement-type transistor ($Q_{27}$).

15. A device according to claim 14, wherein the control means comprises third and fourth resistance means ($R_1'$, $R_2'$) connected in series between the first and second power supply terminals; and inverting-amplifier means (AMP) connected to the first and second power supply terminals, the inverting-amplifier means having an input connected to the connection between the third and fourth resistance means and having an output connected to the gate of the additional enhancement-type transistor ($Q_{27}$).

16. A device according to claim 14, wherein the control means comprises inverting-amplifier means (AMP) connected to the first and second power supply terminals, the inverting-amplifier means having an input connected to the connection between the first and second resistance means and having an output connected to the gate of the additional enhancement-type transistor ($Q_{27}$).

17. A device according to claim 3, wherein the diode means comprises at least one first enhancement-type transistor ($Q_{31}$, $Q_{32}$) having a drain connected to the gate thereof and connected to the first power supply terminal, and a source; the first load means comprises a first depletion-type transistor ($Q_{33}$) having a drain connected to the source of the first enhancement-type transistor, and a gate connected to the source thereof and connected to the second power supply terminal; and wherein the inverter means ($INV_1$) comprises a second depletion-type transistor ($Q_2$) having a drain connected to the first power supply terminal and a gate connected to the source thereof, and a second enhancement-type transistor ($Q_8$) having a drain connected to the source of the second depletion-type transistor ($Q_2$).

18. A device according to claim 17, wherein the inverter means ($INV_1$) further comprises a third enhancement-type transistor ($Q_{37}$) interposed between the source of the second enhancement-type transistor ($Q_8$) and the second power supply terminal, the device further comprising control means for controlling the conductance of the third enhancement-type transistor ($Q_{37}$).

19. A device according to claim 18, wherein the control means comprises diode means ($Q_{34}$, $Q_{35}$) connected to the first power supply terminal; second load means ($Q_{36}$) connected to the diode means and to the second power supply terminal; and inverting-amplifier means (AMP) connected to the first and second power supply terminals, the inverting-amplifier means having an input connected to the connection between the diode means and the second load means and having an output connected to the gate of the third enhancement-type transistor ($Q_{37}$).

20. A device according to claim 18, wherein the control means comprises inverting-amplifier means (AMP) connected to the first and second power supply terminals, the inverting-amplifier means having an input connected to the connection between the diode means and the first load means, and having an output connected to the gate of the third enhancement-type transistor ($Q_{37}$).

21. A device according to any of the preceding claims, wherein the internal circuit comprises a central processing unit (1).

**Patentansprüche**

1. Halbleitervorrichtung mit ersten und zweiten Energieversorgungsanschlüssen, bei der das Potential ($V_{cc}$) bei dem ersten Energieversorgungsanschluß im Betrieb höher als das bei dem zweiten Energieversorgungsanschluß ist und normalerweise in einem Nennbereich (R) liegt; einer internen Schaltung (1), der die Potentiale der ersten und zweiten Energieversorgungsanschlüsse zugeführt werden; einer Energieversorgungspotential-Detektorschaltung (9), die mit den ersten und zweiten Energieversorgungsanschlüssen der inneren Schaltung (1) verbunden ist, um das Potential bei dem ersten Energieversorgungsanschluß zu detektieren und ein Rückstellsignal (RST) für die Rückstellung der internen Schaltung (1) zu erzeugen, wenn das Potential bei dem ersten Energieversorgungsanschluß niedriger als ein vorbestimmter Wert ($V_d$) niedriger als der untere Grenzwert des Nennbereiches ist; und Rückstellsperreinrichtungen, zum Sperren des Effektes des Rückstellsignals, wenn die Vorrichtung in einem Prüfmodus ist, dadurch gekennzeichnet, daß die Rückstellsperreinrichtung ein Flipflop (11) umfaßt, das durch die interne Schaltung (1) gestellt und rückgestellt wird, und eine Gateschaltung (10), die einen ersten Eingang hat, der mit dem Ausgang der Energieversorgungspotential-Detektorschaltung (9) verbunden ist, einen zweiten Eingang, der mit dem Ausgang des Flipflop (11) verbunden ist, und einen Ausgang, der mit der internen Schaltung (1) verbunden ist, wodurch dann, wenn das Flipflop (11) durch die interne Schaltung (1) eingestellt ist, die Gateschaltung (10) die Transmission des Rückstellsignals (RST) erlaubt, und wenn die Halbleitervorrichtung geprüft wird, das Flipflop (11) durch die interne Schaltung zurückgestellt wird, um zu bewirken, daß die Gateschaltung (10) die Transmission des Rückstellsignals (RST) sperrt, um den Betrieb der zu prüfenden Vorrichtung zu ermöglichen, wenn das Energieversorgungspotential in einem Bereich (R') zwischen der unteren Grenze des Nennbereichs und dem vorbestimmten Wert ($V_D$) liegt.

2. Vorrichtung nach Anspruch 1, ferner mit einem Dekoder (12), der mit der inneren Schaltung (1) und mit dem Eingang des Flipflop (11), verbunden ist, wobei der Dekoder (12) angepaßt ist, um das Flipflop (11) zurückzustellen, wenn er von der internen Schaltung (1) eine spezielle Adresse empfängt.

3. Vorrichtung nach Anspruch 1 oder 2, bei der die Energieversorgungspotential-Detektorschaltung (9) umfaßt: eine erste Lasteinrichtung, die mit dem ersten Energieversorgungsanschluß verbunden ist; eine Diodeneinrichtung, die mit der ersten Lasteinrichtung und dem zweiten Energieversorgungsanschluß verbunden ist; eine Invertereinrichtung ($INV_1$), die mit dem ersten und und dem zweiten Energieversorgungsanschluß verbunden ist, wobei die Invertereinrichtung einen Eingang, der mit der Verbindung zwischen der ersten Lasteinrichtung und der Diodeneinrichtung verbunden ist, und einen Ausgang hat; und eine Wellenformereinrichtung, die mit dem ersten und zweiten Energieversorgungsanschlüssen und mit dem Ausgang der Invertereinrichtung verbunden ist, um die Wellenform des Ausgangs der Invertereinrichtung zu formen, um das Rückstellsignal (RST) zu erzeugen.

4. Vorrichtung nach Anspruch 3, bei der die erste Lasteinrichtung einen ersten Verarmungstyp-Transistor ($Q_1$) umfaßt, der ein Drain hat, das mit dem ersten Energieversorgungsanschluß verbunden ist, ein Gate, das mit dem zweiten Energieversorgungsanschluß verbunden ist, und eine Source; die Diodeneinrichtung wenigstens einen ersten Anreicherungs-Transistor ($Q_6$, $Q_7$) umfaßt, der ein Drain hat, das mit seinem Gate verbunden ist und mit der Source des ersten Verarmungstyp-Transistors ($Q_1$) verbunden ist, und eine Source, die mit dem zweiten Energieversorgungsanschluß verbunden ist; und die Invertereinrichtung (INV$_1$) einen zweiten Verarmungstyp-Transistor ($Q_2$) umfaßt, die ein Drain hat, das mit dem ersten Energieversorgungsanschluß verbunden ist, und ein Gate, das mit seiner Source verbunden ist, und einen zweiten Anreicherungstyp-Transistor ($Q_8$), der ein Drain hat, das mit der Source des zweiten Verarmungstyp-Transistors ($Q_2$) verbunden ist.

5. Vorrichtung nach Anspruch 4, bei der die Invertereinrichtung (INV$_1$) ferner einen dritten Anreicherungstyp-Transistor ($Q_{27}$) umfaßt, der zwischen der Source des zweiten Anreicherungstyp-Transistors ($Q_8$) und dem zweiten Energieversorgungsanschluß angeordnet ist, und die Vorrichtung ferner eine Steuereinrichtung zum Steuern der Konduktanz des dritten Anreicherungstyp-Transistors ($Q_{27}$) umfaßt.

6. Vorrichtung nach Anspruch 5, bei der die Steuereinrichtung eine zweite Lasteinrichtung ($Q_{21}$) umfaßt, die mit dem ersten Energieversorgungsanschluß verbunden ist, eine Diodeneinrichtung ($Q_{24}$, $Q_{25}$), die mit der zweiten Lasteinrichtung und dem zweiten Energieversorgungsanschluß verbunden ist; und eine invertierende Verstärkereinrichtung (AMP), die mit den ersten und zweiten Energieversorgungsanschlüssen verbunden ist, welche invertierende Verstärkereinrichtung einen Eingang hat, der mit der Verbindung zwischen der zweiten Lasteinrichtung und der Diodeneinrichtung verbunden ist und einen Ausgang hat, der mit dem Gate des dritten Anreicherungstyp-Transistors ($Q_{27}$) verbunden ist.

7. Vorrichtung nach Anspruch 5, bei der die Steuereinrichtung eine invertierende Verstärkereinrichtung (AMP) umfaßt, die mit den ersten und zweiten Energieversorgungsanschlüssen verbunden ist, und eine invertierende Verstärkereinrichtung, die einen Eingang hat, der mit der ersten Lasteinrichtung verbunden ist, und einen Ausgang, der mit dem Gate des dritten Anreicherungstyp-Transistors ($Q_{27}$) verbunden ist.

8. Vorrichtung nach Anspruch 3, bei der die erste Lasteinrichtung einen P-Kanal-Transistor ($Q_{41}$) umfaßt, der ein Drain hat, das mit dem ersten Energieversorgungsanschluß verbunden ist, ein Gate, das mit dem zweiten Energieversorgungsanschluß verbunden ist, und eine Source; bei der die Diodeneinrichtung wenigstens einen ersten N-Kanal-Transistor ($Q_{46}$, $Q_{47}$) umfaßt, der ein Drain hat, das mit seinem Gate und mit der Source des ersten P-Kanal-Transistors verbunden ist, und eine Source, die mit dem zweiten Energieversorgungsanschluß verbunden ist; und die Invertereinrichtung (INV$_{11}$) einen zweiten P-Kanal-Transistor ($Q_{42}$) umfaßt, der ein Drain hat, das mit dem ersten Energieversorgungsanschluß verbunden ist, ein Gate, das mit der Source des ersten P-Kanal-Transistors verbunden ist, und eine Source, und die Invertereinrichtung (INV$_{11}$) ferner einen zweiten N-Kanal-Transistor ($Q_{48}$) umfaßt, der ein Drain hat, das mit der Source des zweiten P-Kanal-Transistors verbunden ist, ein Gate, das mit dem Gate des zweiten P-Kanal-Transistors verbunden ist und eine Source, die mit dem zweiten Energieversorgungsanschluß verbunden ist.

9. Vorrichtung nach Anspruch 8, bei der die Invertereinrichtung (INV$_{11}$) ferner einen dritten P-Kanal-Transistor ($Q_{54}$) umfaßt, der zwischen dem ersten Energieversorgungsanschluß und dem Drain des zweiten P-Kanal-Transistors angeordnet ist, und einen dritten N-Kanal-Transistor ($Q_{60}$), der zwischen der Source des zweiten N-Kanal-Transistors und dem zweiten Energieversorgungsanschluß angeordnet ist, und die Vorrichtung ferner eine Steuereinrichtung zum gemeinsamen Steuern der Konduktanzen des dritten P-Kanal-Transistors ($Q_{54}$) und des dritten N-Kanal-Transistors ($Q_{60}$) umfaßt.

10. Vorrichtung nach Anspruch 9 bei der die Steuereinrichtung eine zweite Lasteinrichtung ($Q_{52}$) umfaßt, die mit dem ersten Energieversorgungsanschluß verbunden ist; eine Diodeneinrichtung ($Q_{56}$, $Q_{57}$), die mit der zweiten Lasteinrichtung und dem zweiten Energieversorgungsanschluß verbunden ist; und eine invertierende Verstärkereinrichtung (AMP), die mit den ersten und zweiten Energieversorgungsanschlüssen verbunden ist, wobei die invertierende Verstärkereinrichtung einen Eingang hat, der mit der Verbindung zwischen der zweiten Lasteinrichtung und der Diodeneinrichtung verbunden ist, und einen Ausgang hat, der mit den Gates des dritten P-Kanal-Transistors ($Q_{54}$) und des dritten N-Kanal-Transistors ($Q_{60}$) verbunden ist.

11. Vorrichtung nach Anspruch 9, bei der die Steuereinrichtung eine invertierende Verstärkereinrichtung (AMP) umfaßt, die mit den ersten und zweiten Energieversorgungsanschlüssen verbunden ist, die invertierende Verstärkereinrichtung einen Eingang hat, der mit der ersten Lasteinrichtung verbunden ist, und einen Ausgang, der mit dem Gate des dritten P-Kanal-Transistors ($Q_{54}$) und des dritten N-Kanal-Transistors ($Q_{60}$) verbunden ist.

12. Vorrichtung nach Anspruch 1 oder 2, bei der die Energieversorgungspotential-Detektorschaltung erste und zweite Widerstandseinrichtungen ($R_1$, $R_2$) umfaßt, die in Reihe zwischen den ersten und zweiten Energieversorgungsanschlüssen angeschlossen sind; eine Invertereinrichtung (INV$_1$), die zwischen den ersten und zweiten Energieversorgungsanschlüssen angeschlossen ist, welche Invertereinrichtung einen Eingang, der mit der Verbindung zwischen der ersten und der zweiten Widerstandseinrichtung verbunden ist, und einen Ausgang hat; und eine Wellenformereinrichtung, die mit den ersten und zweiten Energieversorgungsanschlüssen und dem Ausgang der Invertereinrichtung verbunden ist, um die Wellenform des Ausgangs der Invertereinrichtung zu formen, um das Rückstellsignal (RST) zu erzeugen.

13. Vorrichtung nach Anspruch 12 bei der die Invertereinrichtung ($INV_1$) einen Verarmungstyp-Transistor ($Q_2$) umfaßt, der ein Drain hat, das mit dem ersten Energieversorgungsanschluß verbunden ist, und ein Gate, das mit seiner Source verbunden ist, und einen Anreicherungstyp-Transistor ($Q_8$), der ein Drain hat, das mit der Source des zweiten Verarmungstyp-Transistors verbunden ist.

14. Vorrichtung nach Anspruch 13, bei der die Invertereinrichtung ($INV_1$) ferner einen zusätzlichen Anreichungs-Transistor ($Q_{27}$) umfaßt, der zwischen der Source des Anreichungstyp-Transistors ($Q_8$) und des zweiten Energieversorgungsanschlusses verbunden ist, wobei die Vorrichtung ferner eine Steuereinrichtung zum Steuern der Konduktanz des zusätzlichen Anreichungstyp-Transistors ($Q_{27}$) umfaßt.

15. Vorrichtung nach Anspruch 14, bei der die Steuereinrichtung dritte und vierte Widerstandseinrichtungen ($R_1'$, $R_2'$) umfaßt, die in Reihe zwischen den ersten und zweiten Energieversorgungsanschlüssen verbunden sind; und eine invertierende Verstärkereinrichtung (AMP), die zwischen den ersten und zweiten Energieversorgungsanschlüssen verbunden ist, wobei die invertierende Verstärkereinrichtung einen Eingang hat, der mit der Verbindung zwischen der dritten und der vierten Widerstandseinrichtung verbunden ist, und einen Ausgang, der mit dem Gate des zusätzlichen Anreichungstyp-Transistors ($Q_{27}$) verbunden ist.

16. Vorrichtung nach Anspruch 14, bei der die Steuereinrichtung eine invertierende Verstärkereinrichtung (AMP) umfaßt, die mit den ersten und zweiten Energieversorgungsanschlüssen verbunden ist, welche invertierende Verstärkereinrichtung einen Eingang hat, der mit der Verbindung zwischen der ersten und der zweiten Widerstandseinrichtung verbunden ist, und einen Ausgang, der mit dem Gate des zusätzlichen Anreichungstyp-Transistors ($Q_{27}$) verbunden ist.

17. Vorrichtung nach Anspruch 3, bei der die Diodeneinrichtung wenigstens einen ersten Anreichungstyp-Transistor ($Q_{31}$, $Q_{32}$) umfaßt, der ein Drain hat, das mit seinem Gate verbunden ist und mit dem ersten Energieversorgungsanschluß verbunden ist, und eine Source; die erste Lasteinrichtung einen ersten Verarmungstyp-Transistor ($Q_{33}$) umfaßt, der ein Drain hat, das mit der Source des ersten Anreichungstyp-Transistors verbunden ist, und ein Gate, das mit seiner Source und mit dem zweiten Energieversorgungsanschluß verbunden ist; und bei der die Invertereinrichtung ($INV_1$) einen zweiten Verar-

mungstyp-Transistor ($Q_2$) umfaßt, der ein Drain hat, das mit dem ersten Energieversorgungsanschluß verbunden ist, und ein Gate, das mit seiner Source verbunden ist, und einen zweiten Anreichungstyp-Transistor ($Q_8$), der ein Drain hat, das mit der Source des zweiten Verarmungstyp-Transistors ($Q_2$) verbunden ist.

18. Vorrichtung nach Anspruch 17, bei der die Invertereinrichtung ($INV_1$) ferner einen dritten Anreichungstyp-Transistor ($Q_{37}$) umfaßt, der zwischen der Source des zweiten Anreichungstyp-Transistors ($Q_8$) und dem zweiten Energieversorgungsanschluß angeordnet ist, und die Einrichtung ferner eine Steuereinrichtung zum Steuern der Konduktanz des dritten Anreicherungstyp-Transistors ($Q_{37}$) umfaßt.

19. Vorrichtung nach Anspruch 18, bei der die Steuereinrichtung eine Diodeneinrichtung ($Q_{34}$, $Q_{35}$) umfaßt, die mit dem ersten Energieversorgungsanschluß verbunden ist; eine zweite Lasteinrichtung ($Q_{36}$), die mit der Diodeneinrichtung und dem zweiten Energieversorgungsanschluß verbunden ist; und eine invertierende Verstärkereinrichtung (AMP), die mit den ersten und zweiten Energieversorgungsanschlüssen verbunden ist, wobei die invertierende Verstärkereinrichtung einen Eingang hat, der mit der Verbindung zwischen der Diodeneinrichtung und der zweiten Lasteinrichtung verbunden ist, und einen Ausgang, der mit dem Gate des dritten Anreichungstyp-Transistors ($Q_{37}$) verbunden ist.

20. Vorrichtung nach Anspruch 18, bei der die Steuereinrichtung eine invertierende Verstärkereinrichtung (AMP) umfaßt, die mit den ersten und zweiten Energieversorgungsanschlüssen verbunden ist, wobei die invertierende Verstärkereinrichtung einen Eingang hat, der mit der Verbindung zwischen der Diodeneinrichtung und der ersten Lasteinrichtung verbunden ist, und einen Ausgang, der mit dem Gate des dritten Anreichunstyp-Transistors ($Q_{37}$) verbunden ist.

21. Vorrichtung nach einem der vorhergehenden Ansprüche, bei der die interne Schaltung eine zentrale Prozessoreinheit (1) umfaßt.

**Revendications**

1. Dispositif semiconducteur comprenant des première et seconde bornes d'alimentation, le potentiel ($V_{cc}$) à la première borne d'alimentation étant supérieur, en cours d'utilisation, à celui présent à la seconde borne d'alimentation et se trouvant normalement dans une gamme nominale (R); un circuit interne (1) auquel les potentiels des première et seconde bornes d'alimentation sont appliqués; un circuit de détection de potentiel d'alimentation (9) connecté aux première et seconde bornes d'alimentation et au circuit interne (1) pour détecter le potentiel sur la première borne d'alimentation et pour produire un signal de remise à zéro (RST) pour remettre à zéro le circuit interne (1) quand le potentiel sur la première borne d'alimentation est inférieur à une valeur prédéterminée ($V_D$) inférieure à la limite inférieure de la gamme nominale; et un moyen d'inhibition de remise à zéro pour inhiber l'effet du signal de remise à zéro quand le dispositif est dans un mode de vérification, caractérisé en ce que le moyen d'inhibition de remise à zéro comprend une bascule (11) mise à un et remise à zéro par le circuit interne (1) et un circuit de porte (10) ayant une première connectée à la sortie du circuit de détection de potentiel d'alimentation (9), une seconde entrée connectée à la sortie de la bascule (11) et une sortie connectée au circuit interne (1), d'où il résulte que, quand la bascule (11) est mis à un par le circuit interne (1), le circuit de porte (10) permet la transmission du signal de remise à zéro (RST) et, quand le dispositif semiconducteur est en cours de vérification, la bascule (11) est remise à zéro par le circuit interne pour amener le circuit de porte (10) à inhiber la transmission du signal de remise à zéro (RST) pour permettre que le fonctionnement du dispositif soit vérifié quand le potentiel d'alimentation se trouve dans une gamme (R') comprise entre la limite inférieure de la gamme nominale et la valeur prédéterminée (V$_D$).

2. Dispositif selon la revendication 1, comprenent en outre un décodeur (12) disposé entre le circuit interne (1) et l'entrée de la bascule (11), le décodeur (12) étant adapté à remettre à zéro la bascule (11) quand il reçoit une adresse particulière en provenance du circuit interne (1).

3. Dispositif selon l'une des revendications 1 ou 2, dans lequel le circuit de détection de potentiel d'alimentation (9) comprend un premier moyen de charge connecté à la première borne d'alimentation; un moyen de diode connecté au prsmier moyen de charge et à la second borne d'alimentation; un moyen inverseur (INV$_1$) connecté aux première et seconde bornes d'alimentation, le moyen inverseur ayant une entrée connectée à la connexion entre le premier moyen de charge et le moyen de diode et ayant une sortie; et un moyen de mise en forme connecté aux première et seconde bornes d'alimentation et à la sortie du moyen inverseur pour mettre en forme le signal de sortie du moyen inverseur pour produire le signal de remise à zéro (RST).

4. Dispositif selon la revendication 3, dans lequel le premier moyen de charge comprend un premier transistor du type à appauvrissement (Q$_1$) ayant un drain connecté à la première borne d'alimentation, une grille connectée à la seconde borne d'alimentation, et une source; le moyen de diode comprend au moins un premier transistor à enrichissement (Q$_6$, Q$_7$) ayant un drain connecté à sa grille et connecté à la source du premier transistor du type à appauvrissement (Q$_1$), et une source connectée à la seconde borne d'alimentation; et le moyen inverseur (INV$_1$) comprend un second transistor du type à appauvrissement (Q$_2$) ayant un drain connecté à la première borne d'alimentation et une grille connectée à sa source, et un second transistor du type à appauvrissement (Q$_8$) ayant un drain connecté à la source du second transistor du type à appauvrissement (Q$_2$).

5. Dispositif selon la revendication 4, dans lequel le moyen inverseur (INV$_1$) comprend un troisième transistor du type à enrichissement (Q$_{27}$) interposé entre la source du second transistor du type à enrichissement (Q$_8$) et la seconde borne d'alimentation, le dispositif comprenant en outre un moyen pour commander la conductance du troisième transistor du type à enrichissement (Q$_{27}$).

6. Dispositif selon la revendication 5, dans lequel le moyen de commande comprend un second moyen de charge (Q$_{21}$) connecté à la première borne d'alimentation; un moyen de diode (Q$_{24}$, Q$_{25}$) connecté au second moyen de charge et à la seconde borne d'alimentation; et un moyen amplificateur inverseur (AMP) connecté aux première et seconde bornes d'alimentation, le moyen amplificateur inverseur ayant une entrée connectée à la connexion entre le second moyen de charge et le moyen de diode et ayant une sortie connectée à la grille du troisième transistor à enrichissement (Q$_{27}$).

7. Dispositif selon la revendication 5, dans lequel le moyen de commande comprend un moyen amplificateur inverseur (AMP) connecté aux première et second bornes d'alimentation, le moyen amplificateur inverseur ayant une entrée connectée au premier moyen de charge et une sortie connectée à la grille du troisième transistor du type à enrichissement (Q$_{27}$).

8. Dispositif selon la revendication 3, dans lequel le premier moyen de charge comprend un transistor à canal P (Q$_{41}$) ayant un drain connecté à la première borne d'alimentation, une grille connectée à la seconde borne d'alimentation, et une source; le moyen de diode comprend au moins un premier transistor à canal N (Q$_{46}$, Q$_{47}$) ayant un drain connecté à sa grille et connecté à la source du premier transistor à canal P, et une source connectée à la seconde borne d'alimentation; et le moyen inverseur (INV$_{11}$) comprend un second transistor à canal P (Q$_{42}$) ayant un drain connecté à la première borne d'alimentation, une grille connectée à la source du premier transistor à canal P et une source, le moyen inverseur (INV$_{11}$) comprenant en outre un second transistor à canal N (48) ayant un drain connecté à la source du second transistor à canal P, une grille connectée à la grille du second transistor à canal P et une source connectée à la seconde borne d'alimentation.

9. Dispositif selon la revendication 8, dans lequel le moyen inverseur (INV$_{11}$) comprend en outre un troisième transistor à canal P (Q$_{54}$) interposé entre la première borne d'alimentation et le drain du second transistor à canal P, et un troisième transistor à canal N (Q$_{60}$) interposé entre la source du second transistor à canal N et la second borne d'alimentation, le dispositif comprenant en outre un moyen de commande pour commander ensemble les conductances du troisième transistor à canal P (Q$_{54}$) et du troisième transistor à canal N (Q$_{60}$).

10. Dispositif selon la revendication 9, dans lequel le moyen de commande comprend un second moyen de charge (Q$_{52}$) connecté à la première borne d'alimentation; un moyen de

diode ($Q_{56}$, $Q_{57}$) connecté au second moyen de charge et à la seconde borne d'alimentation; et un moyen amplificateur inverseur (AMP) connecté aux première et seconde bornes d'alimentation, le moyen amplificateur inverseur ayant une entrée connectée à la connexion entre le second moyen de charge et le moyen de diode et ayant une sortie connectée aux grilles du troisième transistor à canal P ($Q_{54}$) et du troisième transistor à canal N ($Q_{60}$).

11. Dispositif selon la revendication 9, dans lequel le moyen de commande comprend un moyen amplificateur inverseur (AMP) connecté aux première et second bornes d'alimentation, le moyen amplificateur inverseur ayant une entrée connectée au premier moyen de charge et une sortie connectée aux grilles du troisième transistor à canal P ($Q_{54}$) et du troisième transistor à canal N ($Q_{60}$).

12. Dispositif selon l'une des revendications 1 ou 2, dans lequel le circuit de détection de potentiel d'alimentation comprend des premier et second moyens de résistance ($R_1$, $R_2$) connectés en série entre les première et seconde bornes d'alimentation; un moyen inverseur ($INV_1$) connecté aux première et seconde bornes d'alimentation, le moyen inverseur ayant une entrée connectée à la connexion entre les premier et second moyens de résistances, et ayant une sortie; et un moyen de mise en forme de signal connecté aux première et seconde bornes d'alimentation et à la sortie du moyen inverseur pour mettre en forme le signal de sortie du moyen inverseur pour produire le signal de remise à zéro (RST).

13. Dispositif selon la revendication 12, dans lequel le moyen inverseur ($INV_1$) comprend un transistor du type à appauvrissement ($Q_2$) ayant un drain connecté à la première borne d'alimentation et une grille connectée à sa source, et un transistor du type à enrichissement ($Q_8$) ayant un drain connecté à la source du second transistor du type à appauvrissement.

14. Dispositif selon la revendication 13, dans lequel le moyen inverseur ($INV_1$) comprend en outre un transistor supplémentaire du type à enrichissement ($Q_{27}$) interposé entre la source du transistor du type à enrichissement ($Q_8$) et la seconde borne d'alimentation, le dispositif comprenant en outre un moyen de commande pour commander la conductance du transistor supplémentaire du type à enrichissement ($Q_{27}$).

15. Dispositif selon la revendication 14, dans lequel le moyen de commande comprend des troisième et quatrième moyens de résistances ($R_1'$, $R_2'$) connectés en série entre les première et seconde bornes d'alimentation; et un moyen amplificateur inverseur (AMP) connecté aux première et aux seconde bornes d'alimentation, le moyen amplificateur inverseur ayant une entrée connectée à la connexion entre les troisième et les quatrième moyens de résistances et ayant une sortie connectée à la grille du transistor supplémentaire du type à enrichissement ($Q_{27}$).

16. Dispositif selon la revendication 14, dans lequel le moyen de commande comprend un moyen amplificateur inverseur (AMP) connecté aux première et second bornes d'alimentation, le moyen amplificateur inverseur ayant une entrée connectée à la connexion entre les premier et second moyens de résistances et ayant des sorties connectées à la grille du transistor supplémentaire du type à enrichissement ($Q_{27}$).

17. Dispositif selon la revendication 3, dans lequel le moyen de diode comprend au moins un premier transistor du type à enrichissement ($Q_{31}$, $Q_{32}$) ayant un drain connecté à sa grille et connecté à la première borne d'alimentation, et une source; le premier moyen de charge comprend un premier transistor du type à appauvrissement ($Q_{33}$) ayant un drain connecté à la source du premier transistor du type à enrichissement et une grille connectée à sa source, et connecté à la seconde borne d'alimentation; et dans lequel le moyen inverseur ($INV_1$) comprend un second transistor du type à appauvrissement ($Q_2$) ayant un drain connecté à la première borne d'alimentation et une grille connectée à sa source, et un second transistor du type à enrichissement ($Q_8$) ayant un drain connecté à la source du second transistor du type à appauvrissement ($Q_2$).

18. Dispositif selon la revendication 17, dans lequel le moyen inverseur ($INV_1$) comprend en outre un troisième transistor du type à enrichissement ($Q_{37}$) interposé entre la source du second transistor du type à enrichissement ($Q_8$) et la seconde borne d'alimentation, le dispositif comprenant en outre un moyen de commande pour commander la conductance du troisième transistor du type à enrichissement ($Q_{37}$).

19. Dispositif selon la revendication 18, dans lequel le moyen de commande comprend un moyen de diode ($Q_{34}$, $Q_{35}$) connecté à la première borne d'alimentation, un second moyen de charge ($Q_{36}$) connecté au moyen de diode et à la seconde borne d'alimentation; et un moyen amplificateur inverseur (AMP) connecté aux première et second bornes d'alimentation, le moyen amplificateur inverseur ayant une entrée connectée à la connexion entre le moyen de diode et le second moyen de charge, et ayant une sortie connectée à la grille du troisième transistor du type à enrichissement ($Q_{37}$).

20. Dispositif selon la revendication 18, dans lequel le moyen de commande comprend un moyen amplificateur inverseur (AMP) connecté aux première et seconde bornes d'alimentation, le moyen amplificateur inverseur ayant une entrée connectée à la connexion entre le moyen de diode et le premier de charge, et ayant une sortie connectée à la grille du troisième transistor du type à enrichissement ($Q_{37}$).

21. Dispositif selon l'une quelconque des revendications précédentes, dans lequel le circuit interne comprend une unité centrale (1).

# Fig. 1

## Fig. 2

0 096 531

# Fig. 3

# Fig. 4

# Fig. 5

# Fig. 6

# Fig. 7

*Fig. 8*

## Fig. 9

# Fig. 10

# Fig. I I

Fig. 12

# Fig. 13

# Fig. 14

*Fig. 15*

RESET MODE

RESET MODE

Vout Vth

Va

Vcc

Vout

Vout Vth

Va

Vcc

Vout

TIME

POTENTIAL (V)

5

$V_D$

$V_{ao}$

0

$t_0$   $t_1$   $t_2$   $t_3$

## Fig. 16

# Fig. 17